# FASCICULE DE BREVET EUROPEEN

(11) **EP 2 989 510 B1**
(45) Date de publication et mention de la délivrance du brevet: **08.03.2017**
(21) Numéro de dépôt: 14718573.0
(22) Date de dépôt: 16.04.2014
(51) Int. Cl.: G04G 21/08

(54) **PROCÉDÉ DE MANIPULATION D'UN APPAREIL ÉLECTRONIQUE**
BEDIENUNGSVERFAHREN EINES ELEKTRONISCHEN GERÄTS
METHOD FOR HANDLING AN ELECTRONIC DEVICE

(30) Priorité: 24.04.2013 EP 13165187
(43) Date de publication de la demande: 02.03.2016
(73) Titulaire: ETA SA Manufacture Horlogère Suisse, 2540 Grenchen (CH)
(72) Inventeur: BOVET, Jean-Luc, CH-4500 Solothurn (CH); JUFER, Martin, CH-4917 Melchnau (CH); NUSSBAUM, André, CH-2606 Corgémont (CH); CHRISTE, Laurent, CH-2504 Bienne (CH)
(74) Mandataire: Goulette, Ludivine
(86) Numéro de dépôt international: PCT/EP2014/057764
(87) Numéro de publication internationale: WO 2014/173764

(56) Documents cités:
- EP-A1- 0 698 983
- EP-A1- 1 422 583
- CH-B5- 593 509
- US-A- 4 059 955
- US-A- 4 283 784
- US-A- 5 226 022
- US-A- 5 587 971

## Description

L'invention concerne un appareil électronique comprenant un boîtier comprenant une glace et un fond, ledit appareil électronique comprenant au moins un module électronique agencé pour pouvoir exécuter plusieurs fonctions et fournir des informations liées à ces fonctions à des moyens d'affichage disposés sous la glace et des moyens de commande comprenant au moins deux zones de contact sur lesquelles l'utilisateur peut appuyer pour agir sur ledit au moins un module électronique, chaque fonction étant lié à un seuil de temps prédéterminé.

Le module électronique est agencé pour détecter un contact sur ladite au moins une zone de contact afin d'activer la fonction associée au seuil atteint.

### ARRIERE PLAN TECHNOLOGIQUE

Il est connu des appareils électroniques comprenant un écran LCD tactile qui permet d'afficher des informations et d'activer les différentes fonctions de l'appareil.

Par exemple, il est connu des montres comprenant une glace dite tactile présentant sur sa face inférieure des électrodes capacitives servant de touches tactiles. Ces touches sont activées par un poussoir classique. L'utilisateur touche alors l'endroit d'une électrode capacitive pour activer la fonction désirée.

Un inconvénient de cette méthode est que l'utilisateur doit préalablement activer les touches tactiles avant de sélectionner une fonction et donc cela nécessite une manipulation supplémentaire. De plus, cette configuration nécessite d'avoir une touche pour activer une fonction ce qui limite par conséquent le nombre de fonctions que l'appareil peut avoir.

Il est également connu des appareils électroniques muni d'un écran tactile. L'écran tactile comprend différentes touches tactiles. Pour sélectionner une fonction, l'utilisateur effleure, appuie sur une touche tactile puis relâche son appui. Le temps entre l'appui et le relâchement de l'appui est mesurée puis comparée à des seuils prédéfinis. En effet, chaque seuil prédéfini correspond à une fonction de sorte que la durée entre l'appui et le relâchement de l'appui conditionne la sélection d'une fonction particulière.

Un inconvénient de cette méthode est qu'elle est peu précise. En effet, l'utilisateur doit appuyer durant un temps relativement précis pour sélectionner une fonction. Or, la gestion d'une telle durée est complexe et il devient alors fréquent que l'utilisateur sélectionne une fonction autre que celle désirée.

Une solution consiste à avoir des temps bien distincts c'est à dire considérer qu'une durée d'une seconde permet la sélection de la première fonction, qu'une durée de deux secondes permet la sélection d'une seconde fonction, qu'une durée de quatre secondes permet la sélection d'une troisième fonction. L'inconvénient est que la sélection prend donc du temps ce qui peut énerver l'utilisateur.

Des examples d'art antérieur pertinent par rapport à la présente invention sont les suivants: EP 0 698 983 A1, CH 593 509 B5, US 5 226 022 A, EP 1 422 583 A1, US 4 283 784 A et US 4 059 955 A.

### RESUME DE L'INVENTION

L'invention a pour but de pallier les inconvénients de l'art antérieur en proposant de fournir un appareil électronique dont la méthode de gestion des touches tactiles permet une sélection efficace et rapide.

A cet effet, l'invention concerne un appareil électronique tel que défini dans la revendication indépendante 1.

Dans un premier mode de réalisation avantageux, les moyens de commande comprennent trois zones de contact.

Dans un second mode de réalisation avantageux, le module électronique est agencé pour détecter un contact sur au maximum deux zones de contact.

Dans un troisième mode de réalisation avantageux, les différente fonctions sont regroupés en au moins deux série de fonction, chaque série de fonction étant attachée à une zone de contact.

Dans un autre mode de réalisation avantageux, le boîtier est fermé par un fond et une glace sous laquelle les moyens d'affichages sont agencés, les moyens de commande étant agencés au niveau de la glace.

Dans un autre mode de réalisation avantageux, ledit appareil électronique est une montre.

L'invention concerne également une méthode de gestion d'un appareil électronique comprenant un boîtier dans lequel au moins un module électronique est placé, ledit au moins un module électronique étant agencé pour pouvoir exécuter plusieurs fonctions et fournir des informations liées à ces fonctions à des moyens d'affichage, ledit appareil électronique comportant en outre des moyens de commande comprenant au moins une zone de contact sur lesquelles l'utilisateur peut appuyer pour agir sur ledit au moins un module électronique, chaque fonction étant lié à un seuil de temps prédéterminé, caractérisée en ce que la méthode comprend les étapes suivantes :
a) Détecter un contact sur au moins une des zones de contact;
b) Mesurer le temps à partir de ce contact détecté avec un premier compteur;
c) Comparer le temps mesuré avec les seuils de temps prédéterminés des fonctions dudit appareil électronique ;
d) lorsque le temps mesuré est égal à un seuil de temps prédéterminé, stopper la mesure du temps avec le premier compteur, mesurer le temps avec un second compteur et afficher sur les moyens d'affichage que la fonction liée audit seuil de temps prédéterminé est active ;
e) si le contact est toujours détecté lorsque le second compteur atteint une première valeur prédéterminée, reprendre la mesure du temps avec le premier compteur et aller à l'étape c) ; sinon configurer le module électronique de sorte qu'un contact sur au moins une zone de contact permet d'agir sur la fonction sélectionnée.

Dans un premier mode de réalisation avantageux, les moyens de commande comprennent au moins deux zones de contact.

Dans un second mode de réalisation avantageux, les moyens de commande comprennent trois zones de contact.

Dans un autre mode de réalisation avantageux, l'étape a) consiste à détecter un contact sur au maximum deux zones de contact.

Dans un autre mode de réalisation avantageux, les différente fonctions sont regroupés en au moins deux série de fonction, chaque série de fonction étant attachée à une zone de contact.

### BREVE DESCRIPTION DES FIGURES

Les buts, avantages et caractéristiques de l'appareil électronique selon la présente invention apparaîtront plus clairement dans la description détaillée suivante d'au moins une forme de réalisation de l'invention donnée uniquement à titre d'exemple non limitatif et illustrée par les dessins annexés sur lesquels :
- Les figures 1 et 4 représentent schématiquement l'objet portable selon l'invention;
- La figure 2 représente un diagramme de fonctionnement selon un premier mode de réalisation.
- La figure 3 représente un diagramme de fonctionnement selon un second mode de réalisation.

### DESCRIPTION DETAILLEE

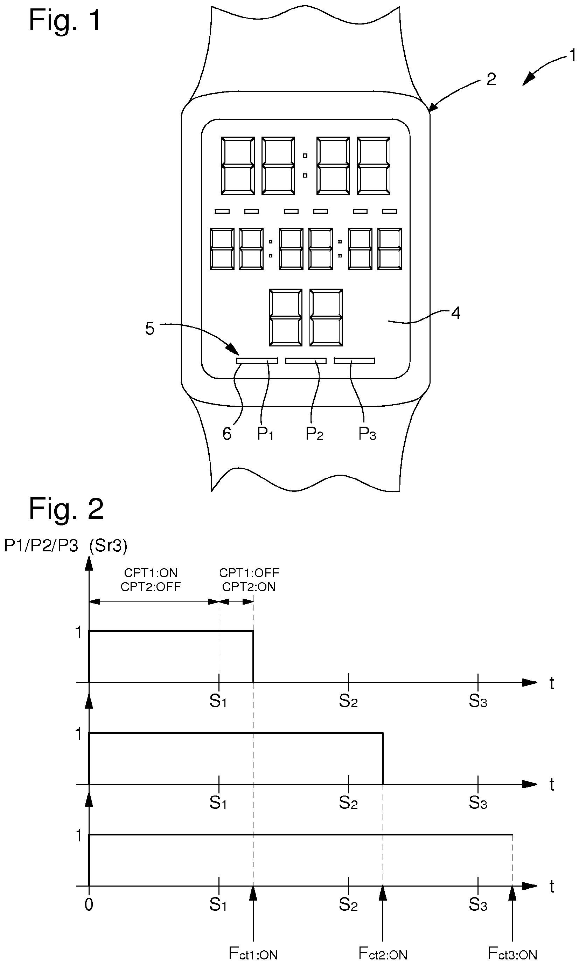

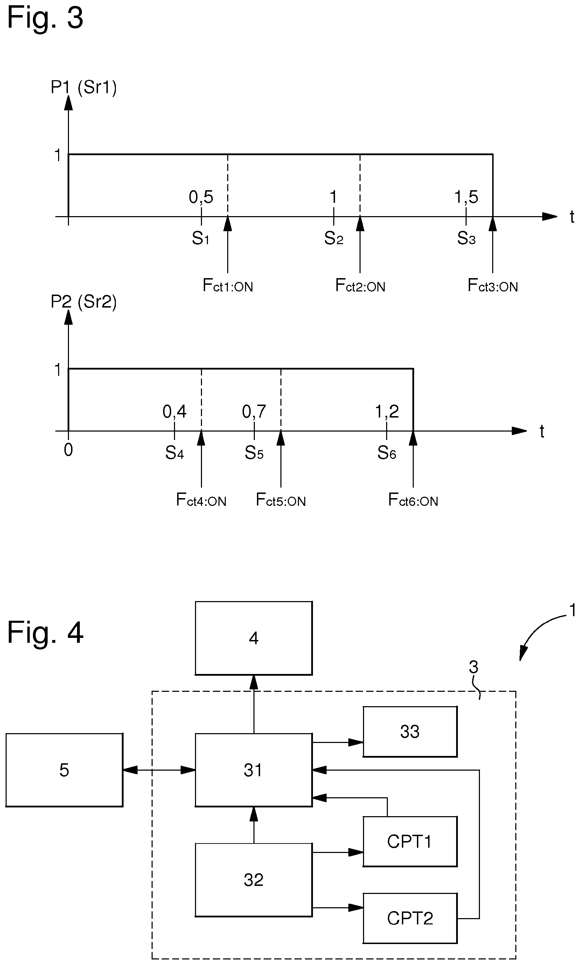

Sur les figures 1 et 4, un objet portable 1 selon l'invention est représenté. Cet objet portable est un appareil électronique tel une montre ou un ordinateur ou une tablette tactile ou un téléphone ou smartphone. Cet appareil comprend un boîtier 2 comprenant une glace et un fond, ledit appareil électronique comprenant au moins un module électronique. Ce module électronique 3 est agencé pour pouvoir exécuter plusieurs fonctions et fournir des informations liées à ces fonctions. Ces informations liées à ces fonctions sont envoyées à des moyens d'affichage 4 disposés sous la glace. Le module électronique 3 peut comprendre un microcontrôleur 31 coopérant avec une base de temps 32 et différents capteurs 33 pour fournir des informations de temps, de pression, de température.

Pour une montre, le module électronique 3 est agencé pour, dans un mode de fonctionnement normal, afficher l'heure courante. Dans un mode de fonctionnement additionnel, le module électronique est agencé pour exécuter l'une des fonctions disponibles, l'utilisateur choisissant la fonction désirée.

Pour contrôler ledit appareil électronique, des moyens de commande 5 sont agencés. Ces moyens de commandes 5 sont agencés au niveau de la glace ou du boîtier. Ces moyens de commande sont des moyens de commandes tactiles 6 c'est-à-dire qu'ils réagissent aux actions des doigts de l'utilisateur. De tels moyens de commande tactiles 6 sont capacitifs c'est-à-dire qu'une électrode est placée sous la glace ou sous le boîtier et que le contact du doigt de l'utilisateur avec la glace ou le boîtier au niveau de l'électrode entraîne une variation de la capacité. Cette variation de la capacité est détectée et est interprétée par le module électronique 3.

Pour l'objet portable selon l'invention, les moyens de commande 5 comprennent au moins deux zones de contact ou touches tactiles sur lesquelles l'utilisateur peut appuyer pour agir sur ledit au moins un module électronique 3. Bien entendu, on comprendra que l'utilisateur peut effleurer, appuyer, frôler ou toucher les zones de contact. Il faut juste qu'une variation de capacité se produise.

Avantageusement, l'invention prévoit que la gestion de ces moyens de commande tactiles 6 est simple.

Pour cela, chaque fonction fct pouvant être exécutée par le module électronique 3 est liée à un seuil S prédéfini. Ce seuil S prédéfini est une valeur de temps. Ainsi, une première fonction fct1 est liée à un premier seuil S1, une seconde fonction fct2 est liée à un second seuil S2 et ainsi de suite. Par exemple, le premier seuil est de 0.5 seconde, le seconde seuil est de une seconde.

Dans un premier mode de réalisation visible à la figure 3, chaque touche tactile est liée à une série Sr de fonctions fct. Par exemple, l'objet portable est doté d'une première touche tactile P1 et d'une seconde touche tactile P2. Chaque série Sr de fonction regroupe des fonctions fct. Ce regroupement peut être fait par thème c'est à dire que les fonctions fct liées au temps sont regroupées dans une série alors que les fonctions liées à un capteur sont regroupées ensemble dans une autre série.

Par exemple, la première série de fonction Sr1 comprend la première fonction fct1 liée au seuil S1, la seconde fonction fct2 liée au seuil S2 et la troisième fonction fct3 liée au seuil S3. La seconde série de fonction Sr2 comprend la quatrième fonction fct4 liée au seuil S4, la cinquième fonction fct5 liée au seuil S5 et la sixième fonction fct6 liée au seuil S6. La première série Sr1 de fonction est liée à la première touche tactile P1 alors que la seconde série Sr2 de fonction est liée à la seconde touche tactile P2. Chaque fonction fct est liée à un seuil S prédéfini.

Premièrement, lorsque l'utilisateur souhaite activer une fonction, il va appuyer, toucher la touche désirée, par exemple la touche tactile P1. Dès que le contact ou l'appui est détecté par le module électronique 3, un premier compteur CPT1 lié au microcontrôleur 31 commence à compter le temps via la base de temps 32.

Ce temps est ensuite comparé aux seuils prédéfinis S des fonctions fct de la série Sr associées à la touche tactile P1.

Deuxièmement, lorsque qu'un seuil S est atteint, le microcontrôleur 31 le détecte et agit en conséquence. Le microcontrôleur 31 stoppe le comptage par le premier compteur CPT1 et affiche sur l'écran une indication disant que la fonction fct1 associée au premier seuil S1 prédéfini atteint est activée.

Simultanément, un second compteur CPT2 commence à compter. Ce comptage est fait de sorte qu'après une première valeur prédéterminée, par exemple, cinq secondes, le microcontrôleur 31 teste si un appui est détecté ou non. Cela permet de confirmer la sélection de la fonction.

Si l'appui n'est plus détecté, le microcontrôleur 31 va interpréter ce relâchement du contact ou de l'appui comme étant une confirmation que la fonction fct1 sélectionnée est celle désirée. L'activation est de la fonction fct1 est donc confirmée. Troisièmement, l'objet portable 1 rentre dans un mode de fonctionnement additionnel dans lequel l'utilisateur n'a plus qu'à utiliser les touches tactiles P1 et P2 pour agir sur la fonction sélectionnée.

Quatrièmement, si l'appui est toujours détecté, le comptage du premier compteur CPT1 reprend. On reprend alors le processus précédent.

Lorsque le premier compteur CPT1 compte jusqu'à atteindre le second seuil Sr2 prédéfini, le microcontrôleur 31 affiche sur l'écran une indication disant que la fonction fct2 est activée. Cette affichage de l'indication disant que la fonction fct2 est activée s'accompagne d'un arrêt du comptage par le premier compteur CPT1.

Le second compteur CPT2 est simultanément remis à zéro et recommence à compter.

Si après la première valeur prédéterminée, l'appui est toujours détecté, le comptage du premier compteur CPT1 reprend sinon la fonction fct2 est activée et l'utilisateur peut agir sur cette fonction.

Pour la dernière fonction fct-n de la première série Sr1, le même processus est réalisé. Si après une première valeur prédéterminée, l'appui est toujours détecté, le microcontrôleur 31 comprend qu'aucune fonction ne doit être exécutée. Il retourne dans le mode de fonctionnement normal dans lequel l'heure courante est affiché.

Dans un second mode de réalisation visible à la figure 2, les différentes fonctions fct sont regroupées en une seule série Sr3. Cette série Sr3 est accessible par les différentes touches tactiles. Par exemple, l'objet portable est doté d'une première touche tactile P1, d'une seconde touche tactile P2 et d'une troisième touche tactile P3. Les opérations de sélection des fonctions sont similaires à celles du premier mode de réalisation.

Premièrement, lorsque l'utilisateur souhaite activer une fonction, il va appuyer sur l'une des touches, par exemple la touche tactile P1. Dès que l'appui est détecté par le module électronique 3, un premier compteur CPT1 commence à compter le temps via la base de temps. Ce temps est ensuite comparé aux seuils prédéfinis S des fonctions fct de la série Sr associées à la touche tactile P1.

Deuxièmement, lorsque qu'un seuil S est atteint, le microcontrôleur 31 le détecte et agit en conséquence. Le microcontrôleur 31 stoppe le comptage par le premier compteur CPT1 et va alors afficher sur l'écran une indication disant que la fonction fct1 associée au premier seuil Sr1 prédéfini atteint est activée.

Lorsque le microcontrôleur affiche l'indication indiquant que la fonction fct1 associée est activée, un second compteur CPT2 commence simultanément à compter. Ce comptage est fait de sorte qu'après une première valeur prédéterminée, par exemple, cinq secondes, le microcontrôleur 31 teste si un appui est détecté ou non.

Si l'appui n'est plus détecté, le microcontrôleur va interpréter ce relâchement de l'appui comme étant une confirmation que la fonction fct sélectionnée est celle désirée. L'utilisateur n'a plus qu'à utiliser les touches tactiles P1 et P2 pour agir sur la fonction sélectionnée.

Si l'appui est toujours détecté, le comptage du premier compteur CPT1 reprend. Lorsque le premier compteur CPT1 compte jusqu'à atteindre le second seuil S2 prédéfini, le microcontrôleur 31 affiche sur l'écran une indication disant que la fonction fct2 est activée. Cette affichage de l'indication disant que la fonction fct2 est activée s'accompagne d'un arrêt du comptage par le premier compteur CPT1 et ainsi de suite.

Le processus se répète jusqu'à la dernière fonction et si celle-ci n'est pas confirmée par l'utilisateur alors le mode normal est affiché.

Le procédé comprend donc les étapes suivantes :
a) Détecter un contact sur au moins une des zones de contact P1, P2, P3;
b) Mesurer le temps à partir de ce contact détecté avec un premier compteur CPT1;
c) Comparer le temps mesuré avec les seuils de temps prédéterminés S des fonctions fct dudit appareil électronique ;
d) lorsque le temps mesuré est égal à un seuil de temps prédéterminé S, stopper la mesure du temps avec le premier compteur CPT1, mesurer le temps avec un second compteur CPT2 et afficher sur les moyens d'affichage que la fonction liée audit seuil de temps prédéterminé est active ;
e) si le contact est toujours détecté lorsque le second compteur atteint une première valeur prédéterminée, reprendre la mesure du temps avec le premier compteur et aller à l'étape c) ; sinon configurer le module électronique de sorte qu'un contact sur une des au moins deux zones de contact permette d'agir sur la fonction sélectionnée.

L'avantage d'un tel mode de réalisation est qu'il permet à l'utilisateur d'activer les différentes fonctions quel que soit la touche tactile utilisée. Ainsi l'utilisateur n'a pas besoin de retenir une combinaison spécifique.

Dans une variante, il peut être prévu que les différentes fonctions fct de la série Sr3 peuvent être sélectionnées lorsque l'utilisateur appuie sur deux zones de contact ou touches tactiles en même temps. Cette variante permet avantageusement de permettre la sélection des différentes fonction même si l'utilisateur n'appuie pas seulement sur une touche et déborde en appuyant sur deux touches. De même, dans le cas où les touches tactiles sont petites et que l'utilisateur possède des doigts de taille conséquente, cela n'a pas d'influence sur la capacité de l'utilisateur à sélectionner et activer des fonctions.

Par contre, il pourra être prévu un dispositif de sécurité empêchant la sélection d'une fonction si un appui sur la totalité des touches tactiles est détecté.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

## Revendications

1. Appareil électronique (1) comprenant un boîtier (2) dans lequel au moins un module électronique (3) est placé, ledit au moins un module électronique étant agencé pour pouvoir exécuter plusieurs fonctions (fct) et fournir des informations liées à ces fonctions (fct) à des moyens d'affichage (4), l'appareil électronique (1) comportant des moyens de commande (5) comprenant au moins une zone de contact (P1) permettant à l'utilisateur d'agir sur ledit au moins un module électronique, chaque fonction étant liée à un seuil de temps (S) prédéterminé, le module électronique étant agencé pour détecter un contact sur ladite au moins une zone de contact afin d'activer la fonction associée au seuil atteint, le module électronique étant **caractérisé en ce qu'**il comprend un premier compteur de mesure du temps pour la sélection de la fonction désirée, ledit premier compteur commençant à mesurer le temps à partir du contact et le comparant aux seuils de temps prédéterminés (S), et un second compteur de mesure du temps pour confirmer ladite sélection, ledit second compteur commençant à mesurer le temps lorsque l'un des seuils de temps prédéterminés est franchi par le premier compteur (S), la mesure du temps du second compteur étant comparée à une première valeur prédéterminée.

2. Appareil électronique selon la revendication 1, **caractérisé en ce que** les moyens de commande (5) comprennent trois zones de contact (P1, P2, P3).

3. Appareil électronique selon la revendication 2, **caractérisé en ce que** le module électronique (3) est agencé pour détecter un contact sur au maximum deux zones de contact.

4. Appareil électronique selon la revendication 2, **caractérisé en ce que** les différentes fonctions sont regroupées en au moins deux séries (Sr) de fonctions, chaque série (Sr) de fonctions étant attachée à une zone de contact.

5. Appareil électronique selon l'une des revendications précédentes, **caractérisé en ce que** le boîtier (2) est fermé par un fond et une glace sous laquelle les moyens d'affichages sont agencés, les moyens de commande (5) étant agencés au niveau de la glace.

6. Appareil électronique selon l'une des revendications précédentes, **caractérisé en ce que** ledit appareil électronique est une montre.

7. Méthode de gestion d'un appareil électronique (1) comprenant un boîtier (2) dans lequel au moins un module électronique (3) est placé, ledit au moins un module électronique étant agencé pour pouvoir exécuter plusieurs fonctions (fct) et fournir des informations liées à ces fonctions (fct) à des moyens d'affichage (4), ledit appareil électronique comportant en outre des moyens de commande (5) comprenant au moins une zone de contact (P1) sur laquelle l'utilisateur peut appuyer pour agir sur ledit au moins un module électronique, chaque fonction étant liée à un seuil de temps (S) prédéterminé, **caractérisée en ce que** la méthode comprend les étapes suivantes :
a) Détecter un contact sur au moins une des zones de contact (P1) ;
b) Mesurer le temps à partir de ce contact détecté avec un premier compteur (CPT1) ;
c) Comparer le temps mesuré avec les seuils de temps prédéterminés (S) des fonctions (fct) dudit appareil électronique ;
d) Lorsque le temps mesuré est égal à un seuil de temps prédéterminé (S), stopper la mesure du temps avec le premier compteur (CPT1), mesurer le temps avec un second compteur (CPT2) et afficher sur les moyens d'affichage (4) que la fonction liée audit seuil de temps prédéterminé est active ;
e) Si le contact est toujours détecté lorsque le second compteur atteint une première valeur prédéterminée, reprendre la mesure du temps avec le premier compteur et aller à l'étape c) ; sinon configurer le module électronique (3) de sorte qu'un contact sur au moins une zone de contact permet d'agir sur la fonction sélectionnée.

8. Méthode de gestion d'un appareil électronique selon la revendication 7, **caractérisée en ce que** les moyens de commande (4) comprennent au moins deux zones de contact (P1, P2).

9. Méthode de gestion d'un appareil électronique selon la revendication 8, **caractérisée en ce que** les moyens de commande comprennent trois zones de contact (P1, P2, P3).

10. Méthode de gestion d'un appareil électronique selon les revendications 8 ou 9, **caractérisée en ce que** l'étape a) consiste à détecter un contact sur au maximum deux zones de contact.

11. Méthode de gestion d'un appareil électronique selon les revendications 7 ou 8, **caractérisée en ce que** les différentes fonctions (fct) sont regroupées en au moins deux séries (Sr) de fonctions, chaque série (Sr) de fonctions étant attachée à une zone de contact.

## Patentansprüche

1. Elektronische Vorrichtung (1), die ein Gehäuse (2) umfasst, in dem mindestens ein elektronisches Modul (3) angeordnet ist, wobei das mindestens eine elektronische Modul dafür ausgelegt ist, mehrere Funktionen (fct) ausführen zu können und Informationen, die mit diesen Funktionen (fct) in Zusammenhang stehen, an Anzeigemittel (4) ausgeben zu können, wobei die elektronische Vorrichtung (1) Steuermittel (5) umfasst, die mindestens eine Berührungsfläche (P1) aufweisen, die dem Anwender ermöglicht, auf das mindestens eine elektronische Modul einzuwirken, wobei jede Funktion mit einem vorgegebenen Zeitschwellenwert (S) in Zusammenhang steht, wobei das elektronische Modul dafür ausgelegt ist, eine Berührung der mindestens einen Berührungsfläche zu detektieren, um die zugeordnete Funktion bei Erreichen des Schwellenwerts zu aktivieren, wobei das elektronische Modul **dadurch gekennzeichnet ist, dass** es einen ersten Zeitmesszähler für die Auswahl der gewünschten Funktion umfasst, wobei der erste Zähler mit der Messung der Zeit ab der Berührung beginnt und sie mit den vorgegebenen Zeitschwellenwerten (S) vergleicht, und einen zweiten Zeitmesszähler umfasst, um die Auswahl zu bestätigen, wobei der zweite Zähler mit der Messung der Zeit beginnt, wenn einer der vorgegebenen Zeitschwellenwerte von dem ersten Zähler (S) überschritten wird, wobei die Zeitmessung des zweiten Zählers mit einem ersten vorgegebenen Wert verglichen wird.

2. Elektronische Vorrichtung nach Anspruch 1, **dadurch gekennzeichnet, dass** die Steuermittel (5) drei Berührungsflächen (P1, P2, P3) umfassen.

3. Elektronische Vorrichtung nach Anspruch 2, **dadurch gekennzeichnet, dass** das elektronische Modul (3) dafür ausgelegt ist, eine Berührung auf höchstens zwei Berührungsflächen zu detektieren.

4. Elektronische Vorrichtung nach Anspruch 2, **dadurch gekennzeichnet, dass** die verschiedenen Funktionen in mindestens zwei Funktionsreihen (Sr) gruppiert sind, wobei jede Funktionsreihe (Sr) mit einer Berührungsfläche verknüpft ist.

5. Elektronische Vorrichtung nach einem der vorhergehenden Ansprüche, **dadurch gekennzeichnet, dass** das Gehäuse (2) durch einen Boden und ein Glas, unter dem die Anzeigemittel angeordnet sind, verschlossen ist, wobei die Steuermittel (5) auf Höhe des Glases angeordnet sind.

6. Elektronische Vorrichtung nach einem der vorhergehenden Ansprüche, **dadurch gekennzeichnet, dass** die elektronische Vorrichtung eine Uhr ist.

7. Verfahren zum Steuern einer elektronischen Vorrichtung (1), die ein Gehäuse (2) umfasst, in dem mindestens ein elektronisches Modul (3) angeordnet ist, wobei das mindestens eine elektronische Modul dafür ausgelegt ist, mehrere Funktionen (fct) ausführen zu können und Informationen, die mit diesen Funktionen (fct) in Zusammenhang stehen, an Anzeigemittel (4) ausgeben zu können, wobei die elektronische Vorrichtung außerdem Steuermittel (5) umfasst, die mindestens eine Berührungsfläche (P1) aufweisen, auf die ein Anwender drücken kann, um auf das mindestens eine elektronische Modul einzuwirken, wobei jede Funktion mit einem vorgegebenen Zeitschwellenwert (S) in Zusammenhang steht, **dadurch gekennzeichnet, dass** das Verfahren die folgenden Schritte umfasst:
a) Detektieren einer Berührung auf mindestens einer der Berührungsflächen (P1);
b) Messen der Zeit ab dieser detektierten Berührung mit einem ersten Zähler (CPT1);
c) Vergleichen der gemessenen Zeit mit den vorgegebenen Zeitschwellenwerten (S) der Funktionen (fct) der elektronischen Vorrichtung;
d) wenn die gemessene Zeit gleich einem vorgegebenen Zeitschwellenwert (S) ist, Beenden der Messung der Zeit mit dem ersten Zähler (CPT1), Messen der Zeit mit einem zweiten Zähler (CPT2) und Anzeigen auf den Anzeigemitteln (4), dass die mit dem vorgegebenen Zeitschwellenwert in Zusammenhang stehende Funktion aktiv ist;
e) falls die Berührung weiterhin detektiert wird, wenn der zweite Zähler einen ersten vorgegebenen Wert erreicht, erneutes Aufnehmen der Zeitmessung mit dem ersten Zähler und Weitergehen zum Schritt c); andernfalls Konfigurieren des elektronischen Moduls (3) in der Weise, dass eine Berührung auf mindestens einer Berührungsfläche ermöglicht, auf die ausgewählte Funktion einzuwirken.

8. Verfahren zum Steuern einer elektronischen Vorrichtung nach Anspruch 7, **dadurch gekennzeichnet, dass** die Steuermittel (4) mindestens zwei Berührungsflächen (P1, P2) umfassen.

9. Verfahren zum Steuern einer elektronischen Vorrichtung nach Anspruch 8, **dadurch gekennzeichnet, dass** die Steuermittel drei Berührungsflächen (P1, P2, P3) umfassen.

10. Verfahren zum Steuern einer elektronischen Vorrichtung nach den Ansprüchen 8 oder 9, **dadurch gekennzeichnet, dass** der Schritt a) darin besteht, eine Berührung auf höchstens zwei Berührungsflächen zu detektieren.

11. Verfahren zum Steuern einer elektronischen Vorrichtung nach den Ansprüchen 7 oder 8, **dadurch gekennzeichnet, dass** die unterschiedlichen Funktionen (fct) in mindestens zwei Funktionsreihen (Sr) gruppiert sind, wobei jede Funktionsreihe (Sr) mit einer Berührungsfläche verknüpft ist.

## Claims

1. Electronic device (1) including a case (2) in which at least one electronic module (3) is placed, said at least one electronic module being arranged to be able to execute several functions (fct) and to provide information relating to said functions (fct) to display means (4), the electronic device (1) further comprising control means (5) including at least one contact area (P1) allowing the user to act on said at least one electronic module, each function being associated with a predetermined time threshold (S), the electronic module being arranged to detect a contact on said at least one contact area in order to activate the function associated with the threshold reached, the electronic module being **characterized in that** it includes a first time measurement counter for selecting the desired function, said first counter starting to measure time starting from the contact and comparing said time to the predetermined time thresholds (S), and a second time measurement counter for confirming said selection, said second counter starting to measure time when one of the predetermined time thresholds is crossed by the first counter (S), the time measurement of the second counter being compared to a first predetermined value.

2. Electronic device according to claim 1, **characterized in that** the control means (5) include three contact areas (P1, P2, P3).

3. Electronic device according to claim 2, **characterized in that** the electronic module (3) is arranged to detect a contact on a maximum of two contact areas.

4. Electronic device according to claim 2, **characterized in that** the various functions are grouped together into at least two series (Sr) of functions, each series (Sr) of functions being attached to a contact area.

5. Electronic device according to any of the preceding claims, **characterized in that** the case (2) is closed by a back cover and a glass underneath which the display means are arranged, the control means (5) being arranged on the glass.

6. Electronic device according to any of the preceding claims, **characterized in that** said electronic device is a watch.

7. Control method for an electronic device (1) including a case (2) in which at least one electronic module (3) is placed, said at least one electronic module being arranged to be able to execute several functions (fct) and to provide information relating to said functions (fct) to display means (4), said electronic device further comprising control means (5) including at least one contact area (P1) which the user can press to act on said at least one electronic module, each function being associated with a predetermined time threshold (S), **characterized in that** the method includes the following steps:
a) Detecting a contact on at least one of the contact areas (P1);
b) Measuring time starting from detection of said contact using a first counter (CPT1);
c) Comparing the measured time to predetermined time thresholds (S) for functions (fct) of said electronic device;
d) When the measured time is equal to a predetermined time threshold (S), stopping the time measurement with the first counter (CPT1), measuring time with a second counter (CPT2) and displaying on the display means (4) an indication that the function associated with said predetermined time threshold is active;
e) If the contact is still detected when the second counter reaches a first predetermined value, restarting the time measurement with the first counter and moving to step c); otherwise configuring the electronic module (3) so that a contact on at least one contact area makes it possible to act on the selected function.

8. Electronic device control method according to claim 7, **characterized in that** the control means (4) include at least two contact areas (P1, P2).

9. Electronic device control method according to claim 8, **characterized in that** the control means include three contact areas (P1, P2, P3).

10. Electronic device control method according to claims 8 or 9, **characterized in that** step a) consists in detecting a contact on a maximum of two contact areas.

11. Electronic device control method according to claims 7 or 8, **characterized in that** the various functions (fct) are grouped together into at least two series (Sr) of functions, each series (Sr) of functions being attached to a contact area.
